Europäisches Patentamt

**European Patent Office**

**Office européen des brevets**

(19)

(11) Numéro de publication: **0 004 520**
**A1**

(12) **DEMANDE DE BREVET EUROPEEN**

(21) Numéro de dépôt: **79430003.8**

(22) Date de dépôt: **04.01.79**

(51) Int. Cl.²: **G 06 F 3/02, G 02 F 1/29**

(30) Priorité: **24.03.78 US 889760**

(43) Date de publication de la demande: **03.10.79**
**Bulletin 79/20**

(84) Etats contractants désignés: **BE CH DE FR GB NL SE**

(71) Demandeur: **International Business Machines Corporation, Armonk, N.Y. 10504 (US)**

(72) Inventeur: **Dahl, Jerome Paul, 4821 Glen Forest Dr., RALEIGH N.C. 27612 (US)**

(74) Mandataire: **Siccardi, Louis, COMPAGNIE IBM FRANCE Département de Propriété Industrielle, F-06610 La Gaude (FR)**

(54) **Clavier à matrice d'éléments diviseurs de faisceaux lumineux.**

(57) Emission de signaux de données au moyen d'un clavier à matrice optique. Des sources lumineuses 1 et des collimateurs 2 dirigent séquentiellement un faisceau lumineux 8 le long des rangées d'une matrice d'éléments diviseurs de faisceaux, 3, commandés par des touches 4. Lorsqu'un élément 3 est placé dans la trajectoire d'un faisceau 8 il réfléchit une partie de ce dernier vers l'un des détecteurs 7 placés sur les colonnes de la matrice, mais laisse passer l'autre partie vers les autres éléments 3 situés en aval, ce qui permet la détection de l'état des autres touches de la même rangée, et permet de résoudre le problème afférent à la situation où une touche est enfoncée avant que la précédente ne soit relâchée. Clavier utilisable notamment comme unité d'entrée de données dans un système de traitement de données.

EP 0 004 520 A1

1

# CLAVIER A MATRICE D'ELEMENTS DIVISEURS DE FAISCEAUX LUMINEUX

## Description

### Domaine Technique

La présente invention concerne les claviers destinés à émettre des signaux représentatifs de données et, plus particulièrement, les claviers à matrice d'éléments optiques commandés par des touches dans lesquels un rayon lumineux émanant d'une source appropriée et traversant une rangée (ou une colonne) de la matrice est sélectivement réfléchi par lesdits éléments optiques dans une ou plusieurs colonnes (ou rangées) aux fins de détection.

### Etat de la technique antérieure

Les brevets des E.U.A. Nos. 3 465 099 et 3 495 239 décrivent des réalisations typiques de claviers optiques dans lesquels un ou plusieurs faisceaux lumineux peuvent être interrompus par des écrans de codage pour créer des combinaisons particulières de faisceaux lumineux venant frapper un ensemble de détecteurs, de manière à coder une représentation de la position de la touche connectée

2

à un écran de codage particulier. Par ailleurs, des touches qui recueillent la lumière qui leur est transmise le long d'un axe donné et qui la réfléchissent le long d'un autre axe ou dans un ou plusieurs plans vers un ou plusieurs détecteurs sont décrites dans les brevets des E.U.A. Nos. 3 676 689 et 3 761 919.

Les éléments électroniques, tels que des générateurs de signaux d'horloge, des compteurs binaires et des décodeurs permettant de décoder la valeur binaire dans les positions de bit de poids plus élevé et de plus faible poids, employés pour détecter les rangées et les colonnes d'une matrice de clavier et détecter leurs signaux sont décrits notamment dans les brevets des E.U.A. No. 3 928 847 et 4 024 534.

Exposé de l'invention

Aucun des dispositifs décrits dans les documents cités ci-dessus ne permet de détecter de façon satisfaisante les signaux distincts émanant de plusieurs touches du clavier qui pourraient se trouver simultanément à l'état enfoncé, sans créer de condition d'erreur dans le signal de sortie. Cela est dû au fait que si plusieurs touches se trouvent simultanément à l'état enfoncé il en résulte une combinaison invalide de faisceaux lumineux détectés par un ensemble de détecteurs, si bien qu'il n'est pas possible d'identifier les différentes touches.

De même, il ne semble pas que l'on ait prévu la détection des signaux engendrés par plusieurs touches simultanément enfoncées dans l'axe d'un unique faisceau lumineux. Un dispositif présentant une telle caractéristique serait pourtant souhaitable en raison de sa simplicité relative, de son coût moins élevé et de la commodité de son emploi.

En conséquence, l'un des objets de la présente invention est de fournir un clavier perfectionné à matrice optique dans lequel la détection et le codage en séquence de l'état de plusieurs touches se trouvant simultanément dans l'état enfoncé puissent être effectués de façon satisfaisante et sans ambiguité ou interférence avec d'autres touches.

Par l'expression "touches se trouvant simultanément dans l'état enfoncé" on veut parler ici du cas où une touche est enfoncée par l'opérateur avant que la touche précédemment enfoncée ne soit relâchée.

Un autre objet de l'invention est de fournir un clavier perfectionné à matrice optique dans lequel plusieurs touches d'une rangée ou d'une colonne donnée vers laquelle un faisceau lumineux est dirigé puissent être détectées correctement et sans ambiguité, indépendamment des autres touches également enfoncées pendant la détection.

Le clavier selon l'invention comporte une matrice d'éléments optiques d'interception de faisceau lumineux. Ces éléments sont des diviseurs de faisceau lumineux qui, lorsqu'ils sont frappés par un faisceau lumineux, réfléchissent une faible partie de ce dernier et en laissent passer la partie restante. Des faisceaux lumineux sont

4

séquentiellement dirigés le long des rangées (ou des colonnes) pour être partiellement réfléchis vers plusieurs colonnes (ou rangées) au moyen desdits éléments optiques qui sont solidaires de touches et qui, lorsque celles-ci sont enfoncées, viennent se placer dans le trajet des faisceaux lumineux aux points d'intersection desdites rangées et colonnes. La partie du faisceau lumineux réfléchie par un élément optique, dont la touche associée est enfoncée, est détectée au moyen d'un détecteur afin d'engendrer un signal représentatif de l'état de cette touche, alors que les états des touches correspondant à des éléments optiques se trouvant en aval dudit élément optique, dans le sens du faisceau lumineux, peuvent être détectés en utilisant la partie non réfléchie de ce faisceau.

Brève description des dessins

La figure 1 représente schématiquement un clavier à matrice optique réalisé conformément aux principes de la présente invention.

La figure 2 représente schématiquement deux positions de touche du type préféré et utilisant des diviseurs de faisceau optique, conformément à l'invention.

La figure 3 représente schématiquement la réalisation d'ensemble d'un système de balayage et de décodage utilisable avec le clavier à matrice optique de l'invention et montrant son mode de fonctionnement préféré.

5

## Description d'un mode de réalisation de l'invention

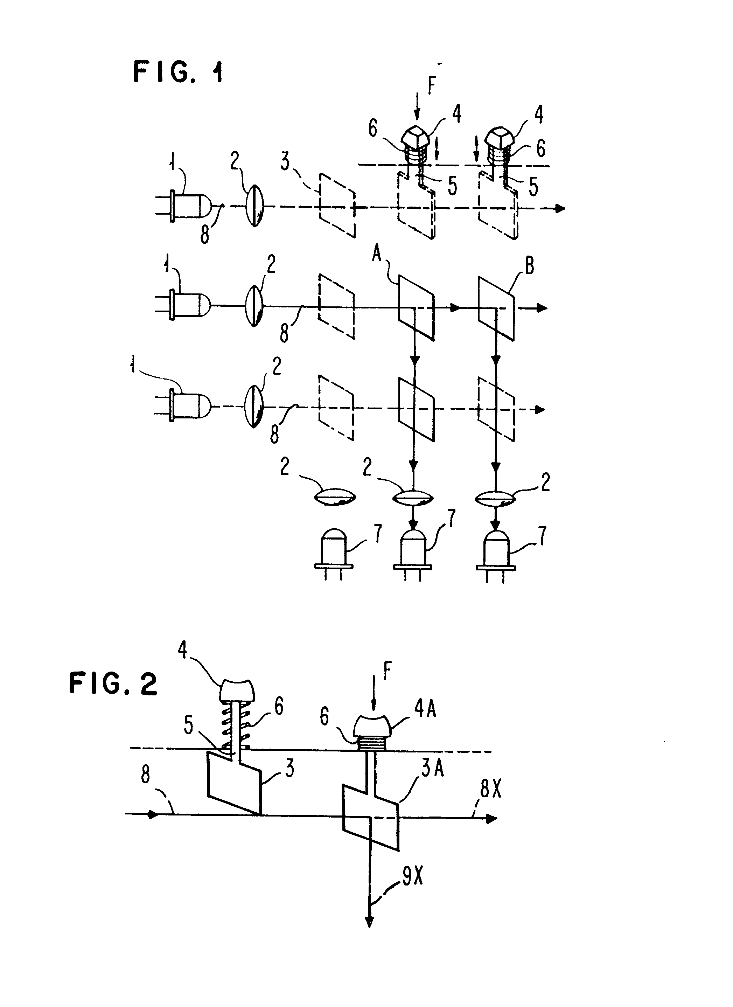

On a représenté sur la figure 1 le clavier préféré de l'invention réalisé sous la forme d'une matrice optique comportant des rangées et des colonnes qui se coupent mutuellement. Des sources de lumière individuelles, qui peuvent être des diodes photoluminescentes, des lampes incandescentes ou toute autre source convenable émettant de la lumière dans la région visible ou invisible du spectre, sont schématiquement représentées en 1. Des lentilles ou des moyens de collimation appropriés 2 sont également représentés schématiquement à proximité des sources de lumière 1 de manière à créer, dans l'exemple représenté sur la figure 1, des faisceaux lumineux 8 dirigés horizontalement et susceptibles d'être interceptés par des diviseurs de faisceau optique 3 si ces derniers sont placés dans leur trajectoire. Les différentes touches 4, dont chacune comprend une tige 5, un ressort de rappel 6 et un diviseur de faisceau optique, sont disposées aux différentes intersections des rangées et des colonnes dans la matrice ainsi constituée. Les éléments 3 sont disposés de manière à se trouver normalement dans la trajectoire des faisceaux lumineux, ou hors de cette trajectoire, jusqu'à ce que les touches 4 soient enfoncées. Lors de l'enfoncement d'une touche 4 donnée, par exemple lorsque le doigt de l'opérateur applique une pression F, l'élément 3 intercepte le faisceau lumineux 8 provenant d'une lentille ou autre moyen de collimation 2, ou au contraire le laisse passer. La lumière provenant d'une source 1 donnée ne forme un faisceau 8 que lorsque cette source 1 est excitée aux fins de la détection de l'état d'une ou plusieurs des touches de la rangée ou de la colonne associée. Les sources lumineuses peuvent évidemment être disposées de telle sorte que la lumière soit dirigée le long des rangées ou le long des colonnes, les diviseurs de faisceau provoquant alors une déviation d'une partie du faisceau vers les colonnes ou vers les rangées, selon le cas.

Des détecteurs optiques individuels 7 sont disposés de manière à pouvoir recevoir la lumière dirigée vers eux depuis l'un quelconque des éléments 3 dans une colonne donnée. Les détecteurs 7 reçoivent la lumière par l'intermédiaire des moyens de focalisation ou de colli- mation 2 représentés schématiquement sur la figure 1.

Chaque élément diviseur de faisceau 3 est tel que, lorsqu'il se trouve dans la trajectoire d'un faisceau lumineux 8 donné, (ce qui est le cas des éléments A et B représentés en traits pleins sur la figure 1) la majeure partie de ce dernier puisse aisément le traverser, le reste de la lumière étant réfléchi vers une colonne donnée, comme le montre la figure. De ce fait, la plus grande partie du faisceau lumineux initial est disponible aux intersections successives de la matrice dans chacune des rangées et peut être partiellement réfléchie par les autres diviseurs de faisceau qui pourraient se trouver dans sa trajectoire par suite de l'enfoncement des touches correspondantes, même si une touche précédente faisant partie de la même rangée a déjà été enfoncée. De la sorte, le faisceau lumineux passe d'une position de touche aux suivantes indépendamment du nombre de diviseurs de faisceau qui peuvent déjà avoir été placés sur sa trajectoire. Ainsi, l'état de chaque touche peut être détecté du fait de la présence

7

ou de l'absence d'une partie réfléchie du faisceau dans une colonne (ou une rangée) donnée et ce, indépendamment du fait que d'autres touches peuvent encore se trouver à l'état enfoncé.

On a représenté de façon plus détaillée sur la figure 2 deux positions de touche individuelles afin de mieux décrire les principes de la présente invention. Chaque touche comporte une tige 5 pourvue à l'une de ses extrémités d'un bouton 4 et à son extrémité opposée d'un diviseur de faisceau 3, et un ressort 6 qui rappelle la touche vers le haut.

Comme on peut le voir sur la figure 2, un faisceau lumineux 8 donné peut passer devant une ou plusieurs positions de touche avant de frapper un diviseur de faisceau 3A donné faisant partie d'une touche 4A donnée. Lorsque cela se produit, une faible partie du faisceau lumineux 8 est réfléchie depuis la surface du diviseur de faisceau et forme un faisceau perpendiculaire 9X, la partie restante du faisceau 8 constituant le faisceau transmis 8X.

Ainsi qu'on le comprendra, on peut faire en sorte que les diviseurs de faisceau 3 ne se trouvent sur la trajectoire des faisceaux lumineux que lors de l'enfoncement des touches correspondantes. Dans la réalisation préférée de l'invention, la plus grande partie (90% environ ou davantage) du faisceau lumineux initial traverse chaque diviseur de faisceau de manière à être disponible à la position de touche suivante dans une rangée donnée, et une partie relativement faible (10% environ ou moins) du faisceau est réfléchie perpendiculairement (ou selon tout autre angle convenable) dans

8

une colonne donnée aux fins d'une détection ultérieure. Les diviseurs de faisceau 3 préférés sont constitués, par exemple, par de la résine à base de polycarbonate, par des matériaux acryliques ou par du polyméthyle de méthacrylate, c'est-à-dire par des matières plastiques optiquement transparentes dont la surface est partiellement réfléchissante. N'importe quel matériau dont les coefficients de transmission et de réflexion sont compris dans la plage préférée peut être utilisé. Les diviseurs de faisceau peuvent être constitués par des éléments en verre partiellement argenté, de façon classique, car, en dépit de leur prix relativement élevé, ils permettent de commander de façon très précise le degré de réflexion/transmission. Par ailleurs, des revêtements sélectivement transparents peuvent être appliqués sur les diviseurs de faisceau afin de sélectionner certaines régions du spectre optique de manière à transmettre ou à réfléchir la lumière dont la longueur d'onde correspond à ces régions.

Ainsi qu'on le verra plus loin, l'emploi, dans le clavier de l'invention, d'une lumière invisible émanant **des sources 1 présente certains avantages.** La région infrarouge ou ultraviolette du spectre optique peut être utilisée en conjonction avec les diviseurs de faisceau 3. Il peut être nécessaire de recouvrir ces derniers de revêtements optiquement transparents ou de revêtements sélectivement transparents afin de pouvoir utiliser ces régions choisies du spectre optique. La lumière infrarouge offre l'avantage de permettre aux détecteurs d'éliminer par filtrage la lumière visible ambiante parasite qui pourrait également être réfléchie par les diviseurs de faisceau. Un revêtement diélectrique anti-réflexion constitué, par exemple, par du

9

fluorure de magnésium, peut être utilisé pour augmenter le coefficient de transmission.

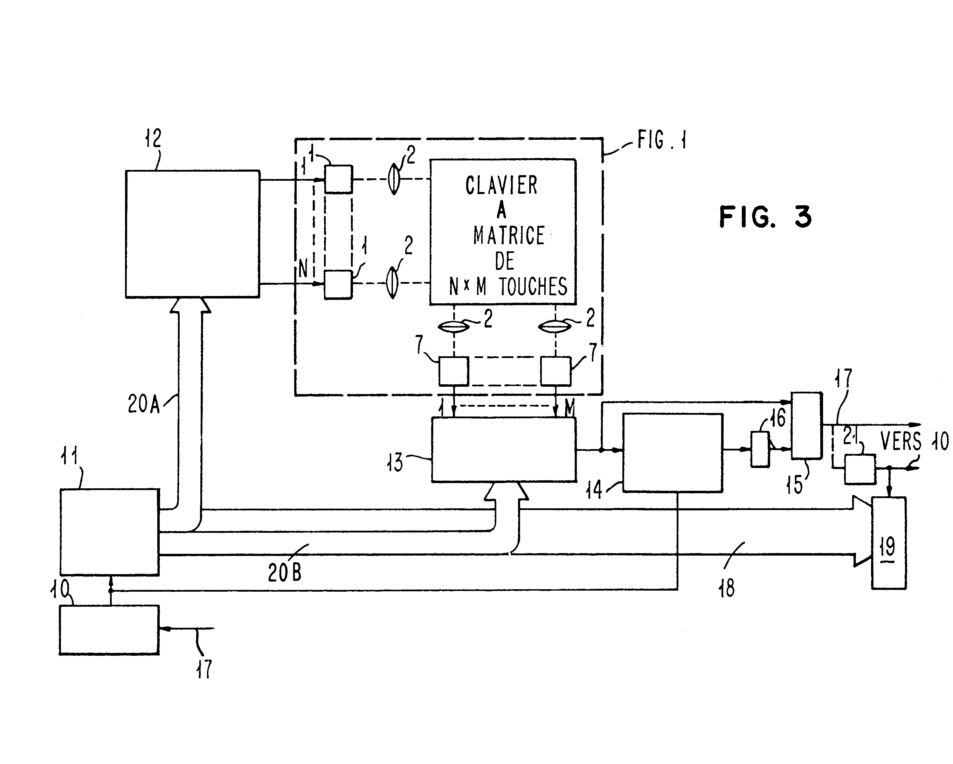

On se référera maintenant à la figure 3 qui représente schématiquement un clavier à matrice optique complet conforme à la présente invention et illustre la façon dont il est utilisé. Les parties déjà décrites à propos de la figure 1 sont encadrées d'une ligne pointillée sur la figure 3. Les autres éléments représentés sur la figure 3 comprennent ceux qui sont normalement requis aux fins d'un balayage électronique de la matrice d'un clavier d'un type quelconque.

La réalisation représentée sur la figure 3 est "balayée" de façon classique. Le système de balayage et de commande représenté comporte un générateur 10 d'impulsions d'horloge, qui peut être un multivibrateur ou tout autre dispositif convenable permettant de former des trains d'impulsions de façon classique. Le générateur 10 fonctionne en principe à une fréquence relativement élevée. Il engendre par exemple plus de 1000 impulsions par seconde. Un compteur 11, qui peut être du type binaire ou décimal, dans une application donnée, reçoit les impulsions engendrées par le générateur 10. Le compteur 11 a une capacité suffisante, au sens binaire, pour compter jusqu'à un nombre au moins égal à NxM, N étant le nombre de rangées et M le nombre de colonnes de la matrice. Les bits individuels de poids le plus élevé provenant des positions supérieures du compteur 11 et les bits individuels de plus faible poids provenant des positions restantes du compteur sont respectivement transmis, par l'intermédiaire de lignes distinctes 20A et 20B, à un décodeur de rangées 12 et à un analyseur ou sélecteur de colonnes 13. Le décodeur 12 peut être

10

constitué par la partie du dispositif qui est afférente au balayage des rangées et permet d'appliquer un signal d'excitation aux différentes sources lumineuses 1 à N associées aux rangées 1 à N dans le cas de la matrice représentée. Le décodeur 12 peut être excité soit par les bits de poids le plus élevé, soit par les bits de plus faible poids fournis par le compteur 11, cela n'affectant aucunement le fonctionnement du dispositif de l'invention. Le décodeur 12 décode les bits qu'il reçoit du compteur 11 et fournit un signal de sortie destiné à exciter une seule des sources lumineuses 1 à N. En supposant que l'on utilise les bits de poids le plus élevé, les bits de plus faible poids devront évidemment tous changer au moins une fois avant que le bit de plus faible poids, parmi les bits de poids élevé, ne soit affecté. La suite de bits de plus faible poids appliquée par la ligne 20B à l'analyseur de colonnes 13 peut donc être décodée de façon séquentielle de manière à permettre de transférer la sortie de l'un quelconque des détecteurs 7 associés aux colonnes 1 à M de la matrice. Ainsi, du fait de la synchronisation de l'excitation des différentes rangées et du décodage individuel de la suite de bits de plus faible poids de manière à pouvoir analyser de façon séquentielle les sorties des différents détecteurs 7, toutes les intersections entre les colonnes et une rangée donnée recevant un faisceau lumineux d'une source 1 donnée peuvent être vérifiées de façon séquentielle afin de déterminer si une ou plusieurs touches 3 ont été enfoncées. L'homme de l'art comprendra que l'état d'enfoncement ou de non enfoncement d'une touche peut être détecté en tant qu'événement significatif ou représentant les données, puisque les détecteurs 7 détectent soit la présence, soit l'absence de lumière.

11

Lorsqu'un détecteur 7 donné a détecté la présence
(ou l'absence) d'un faisceau lumineux réfléchi dans une
colonne de la matrice, l'analyseur de colonnes 13
fournit un signal de sortie qui est appliqué à l'entrée
d'un registre à décalage comportant un nombre d'étages
au moins égal au nombre de touches que comporte la
matrice N x M. Ce signal indique que l'enfoncement d'une
touche a été détecté à un instant donné correspondant à
une adresse donnée ou à la valeur qui était alors celle
du compteur 11. Cette entrée est appliquée afin de
mettre un bit de valeur 1 dans le premier étage du
registre à décalage 14 et est simultanément appliquée à
une porte ET 15, qui reçoit également la sortie d'un
inverseur 16, auquel est appliquée la sortie du registre
14. Si une concordance se produit entre l'entrée actuellement reçue par le registre 14 et la sortie de son
dernier étage, cela signifie que l'état de touche
détecté à cet instant a déjà été détecté lors du cycle
de balayage précédent. Par conséquent, en raison du
signal inversé fourni par l'inverseur 16, la porte ET
15 ne sera pas rendue conductrice et aucun signal
d'échantillonnage ne sera obtenu sur sa ligne de sortie
17. En cas de non concordance, l'état de touche alors
détecté n'ayant pas été détecté précédemment, la sortie
de l'inverseur 16 a le même niveau logique que celle de
l'entrée appliquée par le sélecteur 13 à la porte ET
15, et cette dernière est alors rendue conductrice de
manière à fournir un signal d'échantillonnage sur la
ligne 17.

Ce dernier signal peut être utilisé à différentes fins,
de façon classique. Il peut servir à empêcher le générateur 10 de fournir d'autres impulsions d'horloge
jusqu'à ce que les données fournies sur une ligne

12

18 à un système utilisateur ou à un registre de sortie 19 aient eu le temps d'apparaître. Le signal d'échantillonnage peut être appliqué au registre de sortie 19 afin d'indiquer que les signaux apparaîssant alors dans ce registre doivent être utilisés en tant que données correspondant à la manoeuvre d'une touche donnée. Selon une autre solution, le signal d'échantillonnage peut être appliqué à un système utilisateur (non représenté) pour indiquer que les données apparaissant alors sur la ligne 18 constituent une détection valide de l'enfoncement de touches et sont prêtes à être utilisées.

On notera que la sortie du générateur 10 d'impulsions d'horloge est également appliquée au registre à décalage 14 de manière à provoquer le décalage de son contenu de façon synchronisée avec le compteur 11 et avec les décodeurs 12 et 13, respectivement.

De la sorte, chacune des positions de touche successives sera analysée de façon séquentielle afin de déterminer si une touche a été enfoncée à une intersection donnée de la matrice. Ces détections se produisant dans l'ordre dans lequel l'analyseur fonctionne, quel que soit le nombre de touches qui pourraient effectivement être à l'état enfoncé. Cela, combiné avec le fait que les diviseurs de faisceau optique 3 précédemment décrits n'empêchent pas la totalité de la lumière de parvenir à d'autres positions de touche dans une rangée donnée actuellement excitée, permet d'analyser en séquence des touches se trouvant simultanément à l'état enfoncé et d'obtenir du compteur 11 leurs codes d'adresse correspondants, sans ambiguité. Pour faciliter cette action, on peut utiliser un circuit 21 d'extension de durée d'impulsion de manière à permettre l'application du

13

signal d'échantillonnage au générateur 10 d'impulsions d'horloge pendant un court intervalle de temps avant que le compteur 11 ne puisse avancer davantage aux fins de l'analyse d'autres positions de touche.

La réalisation préférée de l'invention envisage l'emploi de diviseurs de faisceau partiellement transparents et partiellement réfléchissants à chaque intersection d'une matrice optique. Ces diviseurs de faisceau se composent de préférence d'un matériau optiquement transparent/réfléchissant choisi en fonction de la plage optique utilisée dans les sources lumineuses 1. Dans la réalisation préférée, on utilise des émetteurs de lumière infrarouge de 9400 $\overset{\circ}{A}$ de longueur d'onde. Dans cette réalisation préférée, les sources lumineuses 1 sont constituées par des diodes photo-émettrices qui peuvent être excitées pendant 10 microsecondes environ par les circuits de commande que comporte le décodeur 12, de manière à projeter un faisceau lumineux dans la région infrarouge. La lumière visible qui pourrait par inadvertance être reçue par les détecteurs ne comporterait pas une énergie infrarouge suffisante pour les mettre en service lorsqu'ils sont réglés pour un seuil déterminé. Les diodes photo-émettrices 1 peuvent être excitées à un rythme extrêmement rapide. Cela se traduit par une vitesse d'analyse élevée. Le décodeur 12, le sélecteur de colonnes 13, le compteur 11 et le générateur 10 de signaux d'horloge sont des composants standard du commerce.

Application industrielle

La présente invention peut être utilisée en particulier

14

dans les claviers destinés à transmettre des données à un système de traitement de données et devant par exemple fonctionner dans un milieu défavorable dans lequel il existe une interférence électrique importante car celle-ci n'affecte pas les signaux qui se propagent dans la matrice optique. De même, l'emploi de sources de lumière infrarouge et de détecteurs dans la matrice optique permet de réduire considérablement l'interférence créée par les niveaux lumineux qui existent normalement dans les bureaux et les usines.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

0004520

1

REVENDICATIONS

1. Clavier à matrice optique du type comportant:

des éléments optiques d'interception de faisceaux lumineux disposés en matrice, chacun de ces éléments étant solidaire d'une touche dont la manoeuvre provoque le passage de l'élément entre une première et seconde positions dans lesquelles l'élément assure respectivement une fonction de non-interception et une fonction d'interception de faisceau lumineux,

des moyens générateurs de faisceaux lumineux pouvant être commandés pour diriger un faisceau lumineux le long de chaque rangée (ou colonne) de ladite matrice,

des moyens de détection de rayons lumineux, disposés sur les colonnes (ou rangées) de la matrice, en dehors de la zone comportant les points d'intersection desdites rangées et colonnes et destinés à recevoir et détecter les rayons lumineux réfléchis par ceux desdits éléments optiques qui ont été amenés vers leur seconde position, lesdits moyens de détection pouvant être commandés pour émettre un

0004520

2

signal électrique en réponse à leur détection de rayons lumineux,

ledit clavier étant caractérisé en ce que chacun desdits éléments optiques est un élément diviseur de faisceau lumineux, partiellement réfléchissant et partiellement transparent qui réfléchit une partie du faisceau qu'il intercepte vers celui des moyens de détection qui lui est associé et qui laisse passer l'autre partie du faisceau vers les autres éléments optiques situés en aval sur la même rangée (ou colonne) que lui, dans le sens du faisceau lumineux.

2. Clavier selon la revendication 1 caractérisé en ce qu'il comporte en outre des moyens pour commander lesdits moyens générateurs de faisceaux lumineux afin que ceux-ci dirigent séquentiellement un faisceau lumineux le long de chaque rangée (ou colonne) de la matrice et pour commander séquentiellement l'émission de signaux électriques par ceux des moyens de détection de rayons lumineux disposés dans les colonnes (ou rangées) de la matrice qui ont reçu des rayons lumineux réfléchis par ceux des éléments diviseurs de faisceau lumineux qui se trouvent dans ladite seconde position.

3. Clavier selon la revendication 1 ou 2 caractérisé en ce que la lumière émise par lesdits moyens générateurs de faisceaux lumineux se situe dans la partie non visible du spectre.

**FIG. 1**

**FIG. 2**

FIG. 3

CLAVIER
A
MATRICE
DE
N x M TOUCHES

FIG. 1

VERS 10

| Catégorie | Citation du document avec indication, en cas de besoin, des parties pertinentes | Revendica-tion concernée | |
|---|---|---|---|
| | **DOCUMENTS CONSIDERES COMME PERTINENTS** | | **CLASSEMENT DE LA DEMANDE (Int. Cl.²)** |
| X | US - A - 3 648 050 (KOO)<br>* De colonne 1, ligne 57 - colonne 2, ligne 19 *<br><br>-- | 1 | G 06 F 3/02<br>G 02 F 1/29 |
| | US - A - 3 775 560 (EBELING)<br>* De colonne 2, ligne 44 - colonne 3, ligne 26 *<br><br>-- | 2,3 | |
| | US - A - 3 609 713 (WOOTON, NCR)<br>* Colonne 3, lignes 14-68 *<br><br>---- | 2,3 | **DOMAINES TECHNIQUES RECHERCHES (Int. Cl.²)**<br><br>G 06 F |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 01-06-1979 | LEPEE |